# EUROPEAN PATENT SPECIFICATION

(11) **EP 2 958 410 B1**
(45) Date of publication and mention of the grant of the patent: **31.10.2018**
(21) Application number: 13875319.9
(22) Date of filing: 10.12.2013
(51) Int. Cl.: H05K 7/14, H05K 5/02, H01R 13/66, H01R 24/76

(54) **USB POWER OUTLET**
USB-STECKDOSE
PRISE DE COURANT D'ALIMENTATION USB

(30) Priority: 13.02.2013 JP 2013025256
(43) Date of publication of application: 23.12.2015
(73) Proprietor: Panasonic Intellectual Property Management Co., Ltd., Osaka-shi, Osaka 540-6207 (JP)
(72) Inventor: HIRATA, Satoshi, Osaka 571-8501 (JP); MATSUURA, Shuji, Osaka 571-8501 (JP); LO, Chihwei, Taiwan (TW); CHIEN, Chiungyu, Taiwan (TW)
(74) Representative: Appelt, Christian W.
(86) International application number: PCT/JP2013/007244
(87) International publication number: WO 2014/125541

(56) References cited:
- CN-U- 202 585 986
- DE-A1-102007 038 538
- JP-A- H0 465 191
- JP-A- 2002 313 500
- JP-A- 2003 142 790
- JP-A- 2007 075 395
- JP-A- 2007 075 395
- JP-A- 2010 097 876
- US-A1- 2006 077 640

## Description

### Technical Field

The invention relates to a USB power outlet.

### Background Art

For example, JP Pub. No. 2011-82802 discloses a DC outlet having a terminal communication port for POE (Power over Ethernet (Trademark)).

A USB power outlet similar to the DC outlet has been known and includes a printed circuit board on which a USB socket is mounted and a housing that accommodates the printed circuit board and has an insertion hole which allows a USB plug to be inserted into. The USB socket is mounted so that a direction in which the USB plug is plugged or unplugged coincides with a thickness direction of the printed circuit board.

In the USB power outlet there is a possibility that pushing force from the USB plug to the USB socket causes bending deformation of the printed circuit board. If plastic deformation (bending) of the printed circuit board advances as a result of the USB plug being repeatedly plugged in or pulled out of the USB socket, a malfunction may occur such as an obstacle (a jam) to plugging or pulling the USB plug in or out of the USB socket.

CN 202585986 U describes a power socket and particularly relates to an intelligent digital extension socket which combines the power socket and the power output part of a charger or a converter into one. The intelligent digital extension socket comprises at least two unit sockets in series. The unit socket comprises a shell part, a circuit board, an intelligent chip module, an earth leakage protective device, a power supply module, a switch and regulating button, a power input/output interface, a display and alarm device and a unit socket interface. The unit socket comprises a main unit socket, an extension unit socket, and an auxiliary unit socket, wherein the main unit socket comprises a shell part, a circuit board, an intelligent chip module, an earth leakage protective device, a switch and regulating button, a power input/output interface, a display and alarm device and a unit socket interface; the extension unit socket comprises a shell part, a power supply module, a switch and regulating button, a power input/output interface, and a unit socket interface; and the auxiliary unit socket comprises a shell part and a unit socket interface.

US 2006/0077640 (A1) describes an optical module which comprises a substrate, a light-emitting module, a light-receiving module, and a housing. The substrate has a front face and a rear face. The light-emitting module and light-receiving module are mounted to the substrate. The housing receives the substrate. The housing comprises an upper housing and a lower housing. The upper housing is disposed on the rear face side of the substrate and in contact with the rear face. The lower housing is disposed on the front face side of the substrate and in contact with the front face. The substrate is held between the upper housing and lower housing.

### Summary of Invention

The present invention has been achieved in view of the above circumstances, and an object thereof is to provide a USB power outlet capable of suppressing bending of a printed circuit board.

This object is achieved by a USB power outlet according to claim 1.

In an embodiment, the housing (3) includes a cover (6) that has the insertion hole (30) and a body (5) that has the contact part (55).

In an embodiment, the body (5) includes a storage cavity (50) and a partition wall (54) that divides the storage cavity (50) into a terminal storing part (501) and a circuit storing part (502). The contact part (55) protrudes from an end face (540) of the partition wall (54).

In an embodiment, the printed circuit board (2) is shaped like a rectangle extending in one direction (D2). Both ends of the printed circuit board (2) in the direction (D2) are supported by the body (5). The USB socket (1) is mounted on a center part of the printed circuit board (2) in the direction (D2).

In the invention, it is possible to suppress bending of the printed circuit board when the USB plug is connected to the USB socket, in comparison with a case where the contact part is not provided.

### Brief Description of Drawings

Preferred embodiments of the invention will now be described in further details. Other features and advantages of the present invention will become better understood with regard to the following detailed description and accompanying drawings where:
FIG. 1 is a sectional view of a USB power outlet in accordance with an embodiment of the present invention;
FIGS. 2A and 2B are perspective views of the USB power outlet, which are partially broken at different positions, seen from directions opposed to each other;
FIGS. 3A and 3B are perspective views of the USB power outlet, which are partially broken at different positions, seen from directions opposed to each other;
FIG. 4 is a partially broken perspective view of the USB power outlet with a second printed circuit board incorporated in a body;
FIG. 5 is a partially broken perspective view of the USB power outlet;
FIG. 6 is a perspective view of the USB power outlet;
FIG. 7 is a partially broken perspective view of the USB power outlet;
FIG. 8 is a perspective view of the USB power outlet attached to a mounting frame;
FIG. 9 is an exploded perspective view of FIG. 8;
FIG. 10 is a plan view of the body of the USB power outlet; and
FIG. 11 is a bottom view of a cover of the USB power outlet.

### Description of Embodiments

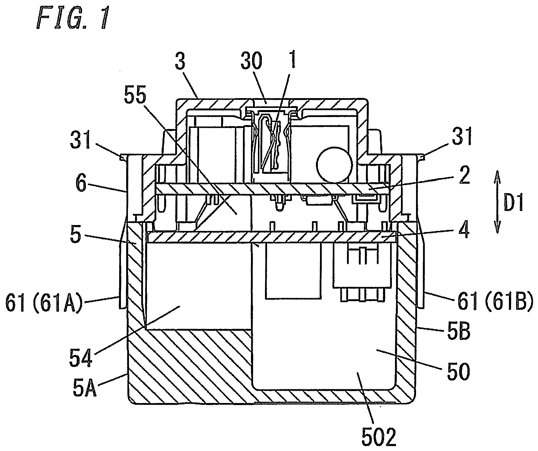

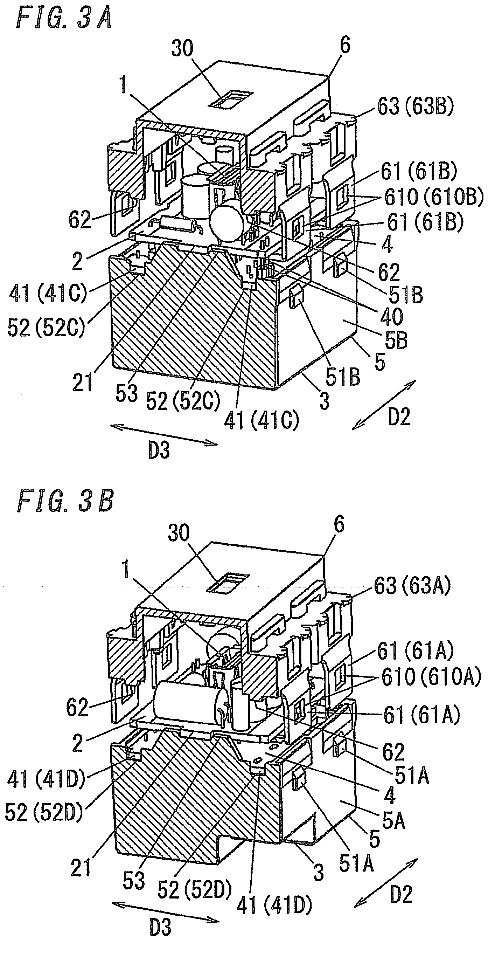

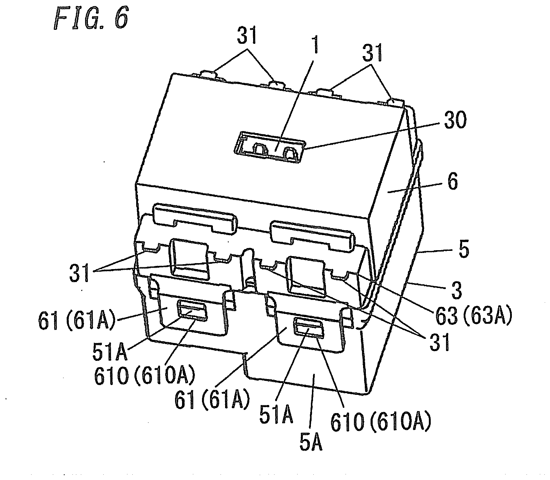

The present embodiment is a USB power outlet (e.g., a USB wall socket). For example, as shown in FIGS. 1 to 9, the embodiment includes a printed circuit board 2 on which a USB socket 1 is mounted, and a housing 3 that accommodates the printed circuit board 2 and has an insertion hole 30 for a USB plug 100 to be connected to the USB socket 1. Hereinafter, the printed circuit board 2 is referred to as a "first printed circuit board". The USB socket 1 is mounted on the printed circuit board 2 so that a direction in which the USB plug 100 is plugged or unplugged corresponds to a direction D1. A first side of the direction D1 (an upper side in FIG. 1) corresponds to a front face side of the USB power outlet. A second side of the direction D1 (a lower side in FIG. 1) corresponds to a rear face side of the USB power outlet, and is also called a "back side". The direction D1 also corresponds to a thickness direction of the first printed circuit board 2.

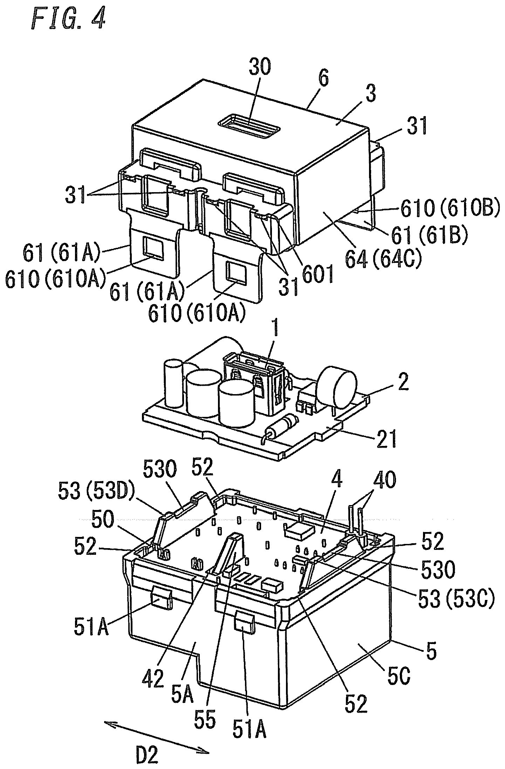

The embodiment further includes an AC-DC converter configured to convert AC power from an external power supply (not shown) into DC power having a predetermined voltage to supply the DC power to the USB plug 100 via the USB socket 1. Some of circuit components constituting the AC-DC converter are mounted on the first printed circuit board 2, and other components thereof are mounted on a second printed circuit board 4. The second printed circuit board 4 is housed in and held by the housing 3 with the board 4 facing a back side of the first printed circuit board 2. As shown in FIG. 4, the first and second printed circuit boards 2 and 4 are electrically connected to each other via conduction paths 40 such as conductive pins for example. The aforementioned AC-DC converter can be realized by well-known technology, and accordingly detailed drawings and explanation thereof have been omitted.

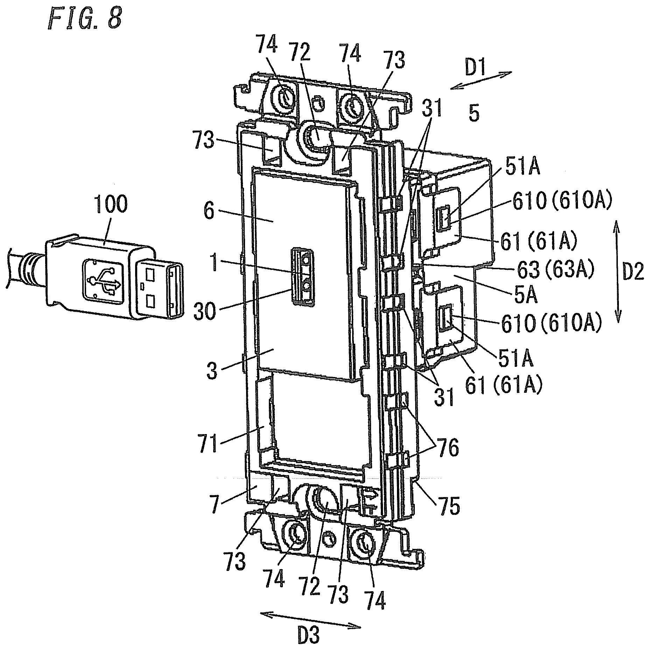

The housing 3 includes a body 5 and a cover 6 that are coupled to each other to sandwich the printed circuit boards 2 and 4 in the direction D1. As shown in FIG. 8, the USB power outlet is configured to be attached to a mounting frame 7 extending in a direction D2 perpendicular to the direction D1. A first side of the direction D2 (an upper side in FIG. 8) corresponds to a left side of the USB power outlet. A second side of the direction D2 (a lower side in FIG. 8) corresponds to a right side of the USB power outlet. A first side of a direction D3 perpendicular to the direction D2 (and the direction D1) (a right side in FIG. 8) corresponds to an upper side of the USB power outlet. A second side of the direction D3 (a left side in FIG. 8) corresponds to a lower side of the USB power outlet.

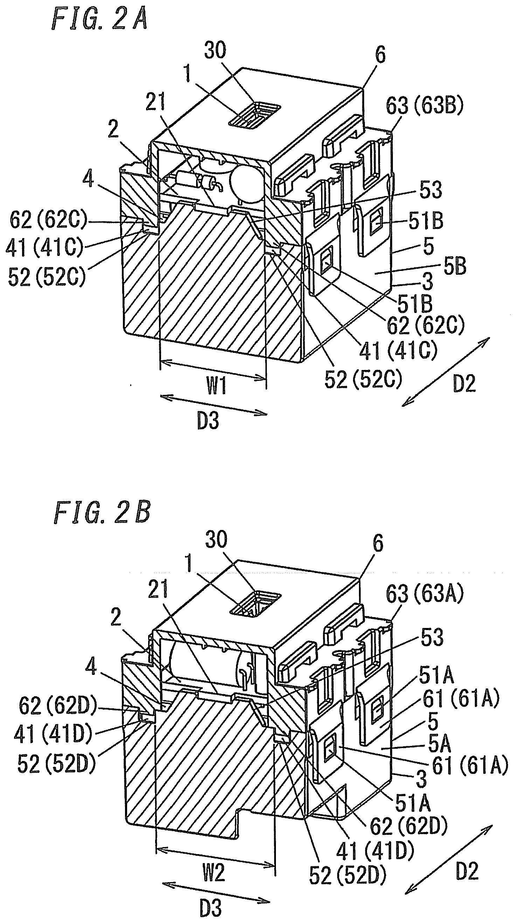

As shown in FIGS. 2A, 2B, 3A, 3B and 8, the body 5 includes lateral parts 5A and 5B on the first and second sides of the direction D3, respectively. The lateral part 5A is provided with two attachment protrusions 51A that are arranged along the direction D2. Similarly, the lateral part 5B is provided with two attachment protrusions 51B that are arranged along the direction D2.

The cover 6 respectively includes a lateral part 63 (63A) and a lateral part 63 (63B) on the first side and the second side of the direction D3 as well. In addition, the cover 6 is provided with two attachment pieces 61 (61A) that extend toward the two attachment protrusions 51A, respectively, and with two attachment pieces 61 (61B) that extend toward the two attachment protrusions 51B, respectively. Specifically, each attachment piece 61A has an attachment hole 610 (610A). The two attachment pieces 61A respectively protrudes toward the two attachment protrusions 51A so that the two attachment protrusions 51A are fit into the attachments holes 610A of the two attachment pieces 61A. Similarly, each attachment piece 61B has an attachment hole 610B. The two attachment pieces 61B respectively protrude toward the two attachment protrusions 51B so that the two attachment protrusions 51B are fit into the attachments holes 610B of the two attachment pieces 61A. As a result, the body 5 and cover 6 are coupled to each other.

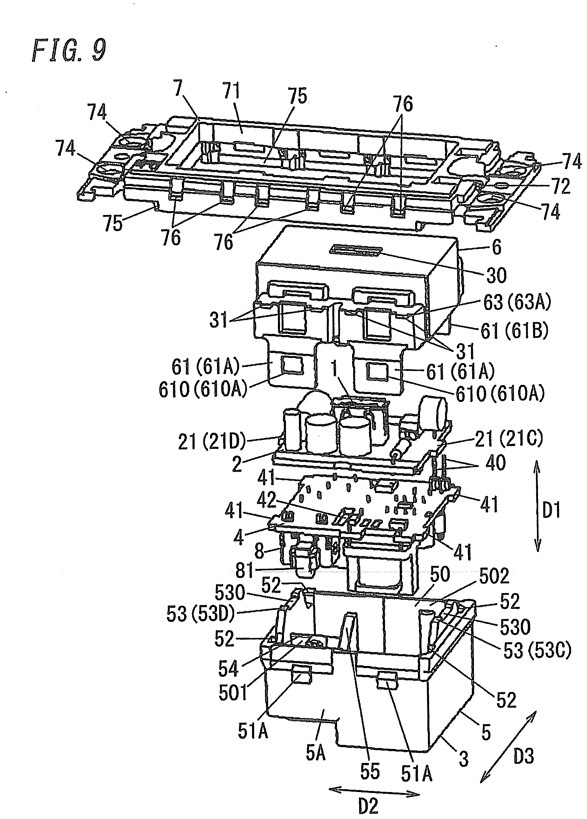

The USB power outlet (the housing 3) is to be fixed to a building face such as a wall face with the mounting frame 7 shown in FIGS. 8 and 9. The mounting frame 7 is shaped like a rectangle having a rectangular hole 71. A length direction of the hole 71 corresponds to the direction D2, and a width direction of the hole 71 corresponds to the direction D3. One round rectangular hole 72 is provided in each end of the mounting frame 7 in the direction D2. Therefore, if box screws inserted into the holes 72 are turned and pressed into holes of a pattress box recessed in the building face, the mounting frame 7 to which the USB power outlet is attached can be therefore fixed to the pattress box.

Two hooked holes 73 are pierced in both sides, between which a corresponding hole 72 is intervened, in the direction D3 of each end of the mounting frame 7 in the direction D2. When a panel (member) forms the building face, each clamping bracket (not shown) is engaged with two hooked holes 73 in each end of the mounting frame 7 and thereby the panel can be clamped between each clamping bracket and the mounting frame 7. That is, the mounting frame 7 to which the USB power outlet is attached can be fixed to the panel.

Surface mounting holes 74 shaped like a circle are pierced in each end of the mounting frame 7 in the direction D2 so that the hooked holes 73 are intervened between the surface mounting holes 74 and the hole 71. Surface mounting screws are each inserted into the surface mounting holes 74 to be turned and pressed into the building face, and thereby the mounting frame 7 to which the USB power outlet is attached can be directly fixed to the building face.

Two retainers 75 shaped like a flat rectangle each protrude backward (toward the second side of the direction D1) from both end edges of the hole 71 in the mounting frame 7 along the direction D2. Three pairs of attachment holes 76 are provided in each retainer 75 to be arranged along the direction D2. The housing 3 (the cover 6) is provided with two pairs of attachment nails 31 which are formed on each lateral part 63A or 63B of the housing 3 along the direction D2 and correspond to two pairs of attachment holes 76 adjoining in the direction D2. Therefore, two pairs of attachment nails 31 of each lateral part 63A or 63B are each fit into two pairs of attachment holes 76 of the mounting frame 7, and thereby the housing 3 is coupled to the mounting frame 7.

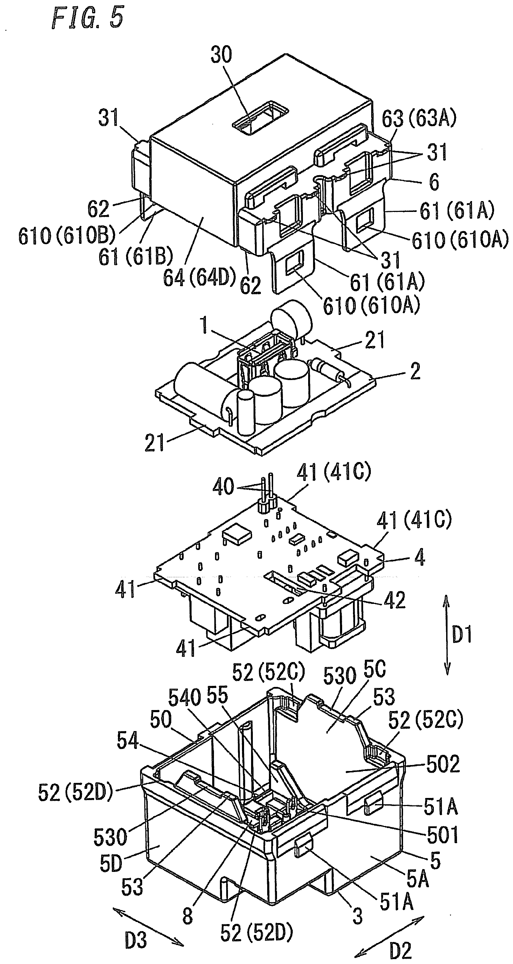

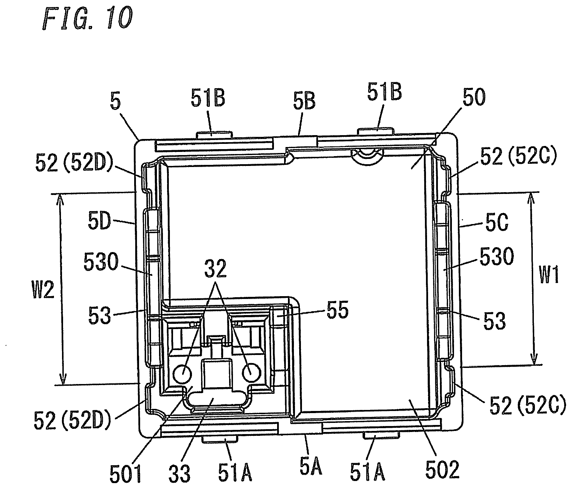

As shown in FIG. 5, the body 5 has a storage cavity 50 with an opening on the first side of the direction D1, and the second printed circuit board 4 is housed in the storage cavity 50. As shown in FIGS. 5 and 10, the body 5 further includes lateral parts 5C and 5D on the first and second sides of the direction D2. The lateral part 5C is provided with two engagement recesses 52 (52C) formed in an inner face of the storage cavity 50. The engagement recesses 52C are arranged at both ends of an edge part of the lateral part 5C. Similarly, the lateral part 5D is provided with two engagement recesses 52 (52D) formed in an inner face of the storage cavity 50. The engagement recesses 52D are arranged at both ends of an edge part of the lateral part 5D. The second printed circuit board 4 has two engagement nails 41 (41C), on the first side of the direction D2, which are each put in the two engagement recesses 52C, while having two engagement nails 41 (41D), on the second side of the direction D2, which are each put in the two engagement recesses 52D. Each engagement nail 41 is put in a corresponding engagement recess 52, thereby preventing the second printed circuit board 4 from being displaced in the directions D2 and D3. In other words, the second printed circuit board 4 is supported by the body 5 at each engagement nail 41.

As shown in FIGS. 4, 5 and 11, the cover 6 further includes a lateral part 64 (64C) and a lateral part 64 (64D) on the first side and the second side of the direction D2, respectively.

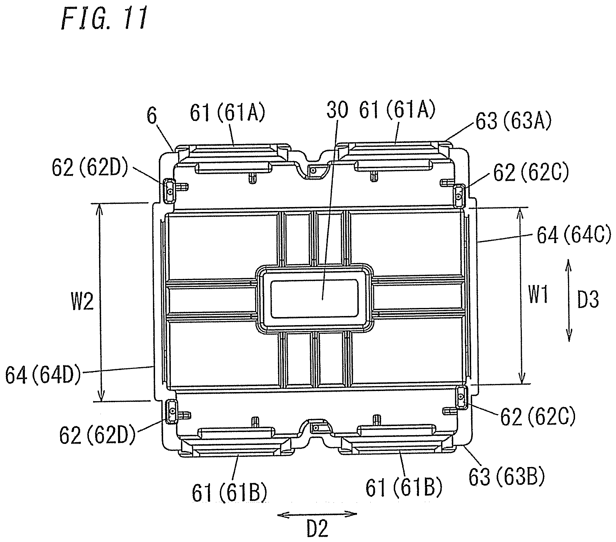

As shown in FIGS. 2A, 2B and 11, the lateral part 64C is provided with two engagement nails 62 (62C) that are each inserted into the two engagement recesses 52C. Similarly, the lateral part 64D is provided with two engagement nails 62 (62D) that are each inserted into the two engagement recesses 52D. Therefore, the engagement nails 41 are each held between the engagement nails 62 of the cover 6 and the engagement recesses 52 of the body 5.

As shown in FIGS. 2A and 2B, a distance W1 between the engagement recesses 52C of the lateral part 5C is set to be smaller than a distance W2 between the engagement recesses 52D of the lateral part 5D. A distance between the engagement nails 62C of the lateral part 64C is set to be almost the same as the distance W1 between the engagement recesses 52C of the lateral part 5C. A distance between the engagement nails 62D of the lateral part 64D is set to be almost the same as the distance W2 between the engagement recesses 52D of the lateral part 5D. Therefore, even if a worker tries to attach the second printed circuit board 4 and the cover 6 to the body 5 in a wrong orientation that is rotated 180° around an axis in parallel with the direction D1 with respect to a correct orientation, the engagement nails 41 and 62 cannot be engaged with the engagement recesses 52. It is accordingly possible to prevent attachment in the wrong orientation.

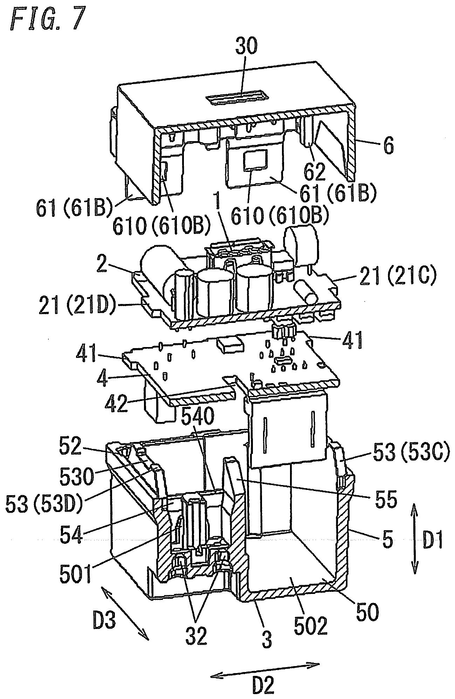

As shown in FIGS. 7 and 9, two wire insertion holes 32 are provided in a face (a back face) of the body 5 on the second side of the direction D1. A terminal 8 is configured to be connected with electric wires (not shown) to be inserted into the wire insertion holes 32 and mounted on a face (a back face), on the second side of the direction D1, of the second printed circuit board 4. The terminal 8 is what is called a quick connection terminal having two locking springs (not shown) that lock the electric wires inserted through the wire insertion holes 32 and correspond one by one to the wire insertion holes 32. The terminal 8 has a release button 81 that is configured, when it is pushed from the second side of the direction D1 (the back side), to push the locking springs, thereby releasing the locking of the electric wires. A release hole 33 (see FIG. 10) through which the release button 81 is exposed backward is provided in the back face of the body 5. A tool (not shown) such as, for example, a slotted screwdriver is inserted into the release hole 33, and thereby the release button 81 can be pushed.

The body 5 has a partition wall 54 that divides the storage cavity 50 into: a terminal storing part 501 that accommodates the terminal 8; and a circuit storing part 502 that accommodates other circuit components. The wire insertion holes 32 and the release hole 33 are formed in a bottom of the terminal storing part 501.

The body 5 further has protruding supports 53 (53C) and 53 (53D) on the first and second sides of the direction D1, respectively. The protruding supports 53C and 53D protrude toward the first side of the direction D1 (forward) from edges of the lateral parts 5C and 5D, respectively. The USB socket 1 is mounted on a front face of the first printed circuit board 2. A back face of the first printed circuit board 2 is in contact with the protruding supports 53C and 53D. That is, the first printed circuit board 2 is supported by the protruding supports 53C and 53D.

Specifically, each of the protruding supports 53 is provided with a recessed support 530 formed in an end face thereof (53). The first printed circuit board 2 is shaped like a rectangle extending in the direction D2, and includes, on the first side of the direction D2, an end that is provided with a leg 21 (21C) further protruding toward the first side thereof. The first printed circuit board 2 also includes, on the second side of the direction D2, an end that is provided with a leg 21 (21D) further protruding toward the second side thereof. The legs 21 are each put in the recessed supports 530, thereby preventing the first printed circuit board 2 from being displaced in the directions D2 and D3. In other words, the legs 21 of the first printed circuit board 2 are supported by the protruding supports 53 of the body 5.

The partition wall 54 is provided with a contact part 55 that protrudes from an end face 540 of the partition wall 54 toward the first side of the direction D1. Specifically, the second printed circuit board 4 has a through hole (a cut) 42 that allows the contact part 55 to pass through. The contact part 55 is formed to pass through the through hole 42 of the second printed circuit board 4 to be in contact with a center part of the back face of the first printed circuit board 2 (i.e., the proximity of the USB socket 1). That is, the contact part 55 is provided so as to be in contact with the first printed circuit board 2 in the proximity of the USB socket 1 from an opposite direction of an insertion direction of the USB plug 100 (the second side of the direction D1) into the USB socket 1. Therefore, when the USB plug 100 is connected to the USB socket 1, the contact part 55 is in contact with the first printed circuit board 2. It is accordingly possible to suppress bending (deformation) of the first printed circuit board 2 like displacement of the center part of the first printed circuit board 2 toward the second side of the direction D1 with respect to the legs 21.

According to the configuration, it is possible to suppress bending of the first printed circuit board 2 when the USB plug 100 is connected to the USB socket 1, in comparison with a case where the contact part 55 is not provided.

## Claims

1. A USB power outlet, comprising:
a first printed circuit board (2) on which a USB socket (1) is mounted; and
a housing (3) that accommodates the first printed circuit board (2) and has an insertion hole (30) for a USB plug (100) to be connected to the USB socket (1);
wherein the first printed circuit board (2) extends in one direction (D2) perpendicular to the direction (D1) in which the USB plug (100) is plugged or unplugged;
wherein the housing (3) is provided with a contact part (55) that is in contact with the first printed circuit board (2) in the proximity of the USB socket (1) from an opposite direction of an insertion direction (D1) of the USB plug (100) into the USB socket (1);
**characterized in that** the USB power outlet further comprises:
a second printed circuit board (4) that is electrically connected to the first printed circuit board (2) via conduction paths (40);
the housing (3) comprises a body (5) and a cover (6) that are coupled to each other to sandwich the first and second printed circuit boards (2, 4) in a direction (D1) in which the USB plug (100) is plugged or unplugged, and
the second printed circuit board (4) has a through hole (42) that allows the contact part (55) to pass through.

2. The USB power outlet of claim 1, wherein the housing (3) comprises:
the cover (6) that has the insertion hole (30); and
the body (5) that has the contact part (55).

3. The USB power outlet of claim 2, wherein
the body (5) comprises a storage cavity (50) and a partition wall (54) that divides the storage cavity (50) into a terminal storing part (501) and a circuit storing part (502), and
the contact part (55) protrudes from an end face (540) of the partition wall (54).

4. The USB power outlet of claim 2 or 3, wherein:
the first printed circuit board (2) is shaped like a rectangle extending in one direction (D2) perpendicular to the direction (D1) in which the USB plug (100) is plugged or unplugged, both ends of the first printed circuit board (2) in the one direction (D2) being supported by the body (5); and
the USB socket (1) is disposed at a center part of the first printed circuit board (2) in the one direction (D2).

## Patentansprüche

1. USB-Steckdose, umfassend:
eine erste gedruckte Leiterplatte (2), auf der eine USB-Buchse (1) angebracht ist; und ein Gehäuse (3), das die erste gedruckte Leiterplatte (2) beherbergt und ein Einführloch (30) für einen USB-Stecker (100) aufweist, der an die USB-Buchse (1) angeschlossen werden soll;
wobei sich die erste gedruckte Leiterplatte (2) in einer Richtung (D2) senkrecht zu der Richtung (D1) erstreckt, in der der USB-Stecker (100) eingesteckt oder abgezogen wird;
wobei das Gehäuse (3) mit einem Kontaktteil (55) versehen ist, das mit der ersten gedruckten Leiterplatte (2) in der Nähe der USB-Buchse (1) aus einer entgegengesetzten Richtung einer Einführrichtung (D1) des USB-Steckers (100) in die USB-Buchse (1) in Kontakt steht;
**dadurch gekennzeichnet, dass** die USB-Steckdose ferner Folgendes umfasst:
eine zweite gedruckte Leiterplatte (4), die mit der ersten gedruckten Leiterplatte (2) über Leiterbahnen (40) elektrisch verbunden ist;
das Gehäuse (3) einen Körper (5) und eine Abdeckung (6) umfasst, die miteinander gekoppelt sind, um die erste und die zweite gedruckte Leiterplatte (2, 4) in einer Richtung (D1) zwischen einander aufzunehmen, in der der USB-Stecker (100) eingesteckt oder abgezogen wird, und die zweite gedruckte Leiterplatte (4) ein Durchgangsloch (42) aufweist, das es dem Kontaktteil (55) erlaubt, hindurchzutreten.

2. USB-Steckdose nach Anspruch 1, wobei das Gehäuse (3) Folgendes umfasst:
die Abdeckung (6), die das Einführloch (30) aufweist; und
den Körper (5), der das Kontaktteil (55) aufweist.

3. USB-Steckdose nach Anspruch 2, wobei
der Körper (5) einen Aufbewahrungshohlraum (50) und eine Trennwand (54) umfasst, die den Aufbewahrungshohlraum (50) in einen Anschlussaufbewahrungsteil (501) und einen Schaltungsaufbewahrungsteil (502) aufteilt, und
das Kontaktteil (55) von einer Stirnseite (540) der Trennwand (54) hervorsteht.

4. USB-Steckdose nach Anspruch 2 oder 3, wobei:
die erste gedruckte Leiterplatte (2) wie ein Rechteck geformt ist, das sich in einer Richtung (D2) senkrecht zu der Richtung (D1) erstreckt, in der der USB-Stecker (100) eingesteckt oder abgezogen wird, wobei beide Enden der ersten gedruckten Leiterplatte (2) in der einen Richtung (D2) von dem Körper (5) getragen werden; und
die USB-Buchse (1) an einem Mittelteil der ersten gedruckten Leiterplatte (2) in der einen Richtung (D2) angeordnet ist.

## Revendications

1. Sortie de puissance USB comprenant :
un premier circuit imprimé (2) sur lequel un port USB (1) est monté ; et
un boîtier (3) qui loge le premier circuit imprimé (2) et qui comprend un trou d'insertion (30) pour une prise USB (100) à connecter au port USB (1) ;
le premier circuit imprimé (2) s'étendant dans une direction (D2) perpendiculaire à la direction (D1) dans laquelle la prise USB (100) est branchée ou débranchée ;
le boîtier (3) étant muni d'une partie de contact (55) qui est en contact avec le premier circuit imprimé (2) à proximité du port USB (1) à partir d'une direction opposée à une direction d'insertion (D1) de la prise USB (100) dans le port USB (1) ;
**caractérisé en ce que** la sortie de puissance USB comprend :
un deuxième circuit imprimé (4) qui est connecté électriquement au premier circuit imprimé (2) par l'intermédiaire de chemins de conduction (40) ;
le boîtier (3) comprend un corps (5) et un couvercle (6) qui sont couplés entre eux afin de prendre en sandwich les premier et deuxième circuits imprimés (2, 4) dans une direction (D1) dans laquelle la prise USB (100) est branchée ou débranchée et
le deuxième circuit imprimé (4) comprend un trou traversant (42) qui permet à la partie de contact (55) de passer à travers.

2. Sortie de puissance USB selon la revendication 1, dans laquelle le boîtier (3) comprend :
le couvercle (6) qui comprend le trou d'insertion (30) ; et
le corps (5) sui comprend la partie de contact (55).

3. Sortie de puissance USB selon la revendication 2, dans laquelle
le corps (5) comprend une cavité de stockage (50) et une cloison (54) qui divise la cavité de stockage (50) en une partie de stockage de borne (501) et une partie de stockage de circuit (502) et
la partie de contact (55) dépasse d'une face d'extrémité (540) de la cloison (54).

4. Sortie de puissance USB selon la revendication 2 ou 3, dans laquelle :
le premier circuit imprimé (2) présente la forme d'un rectangle s'étendant dans une direction (D2) perpendiculaire à la direction (D1) dans laquelle la prise USB (100) est branchée ou débranchée, les deux extrémités du premier circuit imprimé (2) dans la direction (D2) étant supportées par le corps (5) ; et
le port USB (1) est disposé au niveau d'une partie centrale du premier circuit imprimé (2) dans la direction (D2).
